# EUROPÄISCHE PATENTSCHRIFT

(11) **EP 0 883 129 B1**
(45) Veröffentlichungstag und Bekanntmachung des Hinweises auf die Patenterteilung: **09.04.2003**
(21) Anmeldenummer: 98109156.4
(22) Anmeldetag: 20.05.1998
(51) Int. Cl.: G11C 5/00

(54) **Elektronische Speichervorrichtung, insbesondere zur Anwendung bei implantierbaren medizinischen Geräten**
Electronic memory device, especially suited for implanting medical devices
Dispositif de mémoire électronique, spécialement conçu pour implanter des dispositifs médicaux

(30) Priorität: 07.06.1997 DE 19724053
(43) Veröffentlichungstag der Anmeldung: 09.12.1998
(73) Patentinhaber: BIOTRONIK Mess- und Therapiegeräte GmbH & Co Ingenieurbüro Berlin, 12359 Berlin (DE)
(72) Erfinder: Feese, Ulrich, 14167 Berlin (DE)
(74) Vertreter: Hübner, Gerd, Dipl.-Phys.

(56) Entgegenhaltungen:
- EP-A- 0 702 980
- US-A- 5 345 412
- US-A- 5 680 342

## Beschreibung

Die Erfindung betrifft eine elektronische Speichervorrichtung, insbesondere zur Anwendung bei implantierbaren medizinischen Geräten, mit den im Oberbegriff des Anspruches 1 angegebenen Merkmalen.

Derartige integrierte Speichervorrichtungen mit einem oder mehreren elektronischen Schreib/Lese-Speicherbausteinen- üblicherweise mit RAM (=Random Access Memory) bezeichnet - sind im Stand der Technik grundsätzlich bekannt und weitverbreitet. So werden diese Speichervorrichtungen in Personalcomputern, integrierten Computersystemen usw. als Arbeitsspeicher verwendet.

Herkömmlicherweise werden eine oder mehrere solcher RAM-Bausteine auf einer mit gedruckten Leitungsbahnen versehenen Platine gehalten, wie zum Beispiel aus der US 5 345 412 A bekannt. Die Platine ist Träger, dient also zur mechanischen Fixierung und Kontaktierung der Anschlüsse der RAM-Bausteine. Der RAM-Baustein selbst weist üblicherweise einen Aktivier/Deaktivier-Eingang, einen Schreib/Lese-Eingang, einen Datenbus-Anschluß und mehrere Adresseingänge auf. Nähere Ausführungen hierzu erübrigen sich, da sie zum allgemeinen Fachwissen gehören.

Die der vorliegenden Erfindung zugrundeliegende Problematik stellt sich insbesondere auf dem Gebiet implantierbarer Herzschrittmacher, bei denen die Verwendung von RAM-Bausteinen bereits bekannt ist. Beispielsweise beschreibt die GB-A-20 26 870 einen mikroprozessor-gesteuerten Herzschrittmacher, in dem ein RAM-Baustein einzelne Stimulationsparameter oder ganze Stimulationsprogramme speichert. Aus der US-A-4 223 678 sind RAM-Bausteine auch als Speicher für digitalisierte EKG-Sequenzen und bestimmte kardiologische Ereignisse bekannt.

Zum Hintergrund der Erfindung ist auszuführen, daß bei medizinischen Implantaten, wie Herzschrittmachern, als Substrate, die die RAM-Bausteine tragen, Keramikplatten eingesetzt werden, die eine hohe Dauerstabilität und Zuverlässigkeit gewährleisten und eine hohe Packungsdichte bei der Bauelement-Bestückung erlauben.

Die elektrische Verbindung der gehäuselosen Bauteile mit den Leiterbahnen des Substrat wird über sogenannte Bond-Verbindungen hergestellt, wofür substratseitig Kontaktier-Flächen, sogenannte Bond-Pads, vorgesehen sind. Über solche Bond-Pads kann eine elektrische Verbindung zwischen einer elektrischen Leiterbahn einerseits und einem Anschlußbein eines elektronischen Bauteils andererseits hergestellt werden. Dies wird als sogenanntes "Die-To-Substrat-Band" bezeichnet.

Als Alternative dazu können auch elektronische Bauteile und Bausteine untereinander direkt über bauteilseitige Bond-Pads und elektrische Leitungen verbunden werden. Dies wird als sogenanntes "Die-To-Die-Bond" bezeichnet.

Grundsätzlich ist die Anzahl der Bauteile, die auf einem gemeinsamen Substrat plaziert werden können, durch die Substratoberfläche eingeschränkt. Auch die Komplexität der Leiterbahnen, die mit wachsender Bauteilzahl zunimmt, ist durch die Substratoberfläche eingeschränkt, da die Leiterbahnen auf der Substratoberfläche nur zweidimensional, d. h. kreuzungsfrei, geführt werden können. Aufwendige Abhilfe in diesem Zusammenhang ermöglichen Substrate, bei denen Leiterbahnen in mehreren voneinander getrennten Ebenen geführt werden. Die Anzahl der Bauelemente ist ferner durch die Anzahl ihrer Anschlußbeine begrenzt, da hierfür die erforderlichen Bond-Pads auf der Substratoberfläche Platz finden müssen.

Ausgehend von dieser Hintergrundbetrachtung sind im Hinblick auf das Einsatzgebiet der Erfindung, nämlich die Anwendung bei implantierbaren medizinischen Geräten, die folgenden spezifischen Nachteile des Standes der Technik herauszuarbeiten:

So ist bei der Anwendung herkömmlicher RAM-Bausteine, die regelmäßig vor allem hinsichtlich Speicher-Kapazität und Speicher-Zugriffsgeschwindigkeiten optimiert sind, in Implantaten die fehlende Flexibilität bei der Anpassung der Speicherkapazität und damit auch des Bauvolumens und des Stromverbrauches zu kritisieren. Einerseits ist mit der Auslegung der Kontaktflächen und der elektrischen Verbindungen auf dem Substrat auch die Größe des anbringbaren RAM-Bausteins für ein bestimmtes Substrat unabänderlich festgelegt, andererseits muß jeweils für eine bestimmte Anwendung eigens ein hinsichtlich seiner Speicherkapazität angepaßter RAM-Baustein entwickelt werden. Damit ist abhängig von der Anzahl verschiedener Anwendungen auch die Entwicklung einer ebensolchen Anzahl verschiedener RAM-Bausteine erforderlich, obgleich die Herstellung eines einheitlichen und für verschiedene Speicheranforderungen verwendbaren Speicherbausteins in größeren Stückzahlen wirtschaftlicher wäre.

Ferner ist auch die im Stand der Technik übliche Verbindung zwischen RAM-Baustein und dem jeweiligen Substrat nachteilig, da bei Verwendung mehrerer RAM-Bausteine für jeden einzelnen Baustein eine Vielzahl von Kontaktflächen auf dem Substrat erforderlich ist, die eine relativ große Fläche beanspruchen. Zusätzlich müssen noch weitere Bauelemente zur Aktivierung/Deaktivierung der einzelnen Bausteine (Adressendecoder) auf dem Substrat untergebracht werden.

Darüber hinaus werden üblicherweise bei Verwendung mehrerer RAM-Bausteine diese mittelbar über das Substrat verbunden, so daß eine hohe Anzahl von substratseitigen Kontakten herzustellen ist. Zusätzlich werden bei der Signalübertragung in den auf dem Substrat gedruckten Leiterbahnen durch dessen dielektrische Eigenschaften Energieverluste verursacht.

Dies ist um so mehr nachteilig, als die in Implantaten eingesetzten Lithium-Batterien mit einer Spannung von 2,8 V die erforderlichen Betriebsspannungen üblicher RAM-Bausteine in der Regel nicht erreichen.

Ausgehend von der geschilderten Problematik zum Stand der Technik liegt der Erfindung die Aufgabe zugrunde, eine elektronische Speichervorrichtung insbesondere zur Anwendung bei implantierbaren medizinischen Geräten zu schaffen, die in kompakterer Weise realisierbar und hinsichtlich ihrer Speicherkapazität sehr flexibel auslegbar ist.

Diese Aufgabe wird durch die im Kennzeichnungsteil des Anspruches 1 angegebene Architektur des oder der einzelnen RAM-Bausteine der erfindungsgemäßen Speichervorrichtung gelöst. Demnach ist grundsätzlich vorgesehen, daß der oder die RAM-Bausteine jeweils mit zwei Schnittstellen versehen sind, die eingangsseitig und ausgangsseitig angeordnet sind. Adressbus-, Datenbus- und Schreib/Lese-Anschluß dieser Schnittstellen sind jeweils intern zur Signaldurchleitung durch den RAM-Baustein miteinander verbunden. Damit ist die Voraussetzung dafür geschaffen, daß mehrere RAM-Bausteine hintereinander durch direkte elektrische Verbindungen - also ohne über das Substrat zu gehen - aneinander gekoppelt werden können. Im Zusammenhang mit dem Datenbus ist darauf hinzuweisen, daß hier je nach Richtung des Datenflusses die eingangsseitige Schnittstelle auch als Signalausgang und die ausgangsseitige Schnittstelle als Signaleingang wirken.

Ein weiterer Vorteil der durch die erfindungsgemäße Architektur möglichen direkten Baustein-Verbindung und -Verkettung bei Verwendung mehrerer Bausteine liegt in der Einsparung einer Vielzahl von ansonsten notwendigen substratseitigen Kontaktflächen und Leiterbahnen, wodurch die Substratfläche besser ausnutzbar ist und damit die Komplexität und Pakkungsdichte für andere Bauteile erhöht werden können. Ferner werden aufgrund der fehlenden Dämpfung durch das dielektrische Material bei der direkten Leitungsverbindung Energieverluste bei der Signalübertragung vermieden. Insofern können bei der vorgegebenen Versorgungsspannung der üblicherweise verwendeten Lithium-Batterien Speichervorrichtungen mit höherer Kapazität realisiert werden, als mit üblichen RAM-Bausteinen.

Wie im Anspruch 2 angegeben ist, benötigt die erfindungsgemäße Speichervorrichtung auch bei Vorsehen mehrerer RAM-Bausteine allenfalls eine jeweils einzige Baustein-Substrat-Verbindungsleitung für jeden Adress- und Datenbus-Anschluß sowie den Schreib/Lese-Eingang.

Alle weiteren Verbindungen bei Verwendung mehrerer RAM-Bausteine können über eine kaskadenartige Kopplung dieser Bausteine über direkte Baustein-Verbindungsleitungen ("Die-To-Die-Bonds") verbunden sein, wie dies Anspruch 3 wiedergibt.

Gemäß den Ansprüchen 4 und 5 ist eine Adresserweiterungs-Einrichtung auf den RAM-Bausteinen der Vorrichtung vorgesehen, durch die ein binärer Eingangswert als Adresseingangssignal eingegeben und mit einem vorgegebenen Sollwert verglichen wird. Stimmen Eingangswert und Sollwert überein, wird der jeweilige RAM-Baustein aktiviert. Der binäre Eingangswert wird ferner in der Adresslogik der Adresserweiterungs-Einrichtung nach einem vorgegebenen Algorithmus in einen binären Ausgangswert konvertiert und über einen Ausgangsanschluß an die Adresserweiterungs-Einrichtung des folgenden RAM-Bausteins als Eingangswert weitergegeben. Durch diese Struktur ist eine hierarchische Ordnung erreichbar, mittels der ein bestimmter Baustein aus einer Reihe von hintereinander geschalteten RAM-Bausteinen angesprochen werden kann, ohne daß eigene Adressdecoder auf dem Träger notwendig wären. In vorteilhafter Weise enthält dabei die Adresslogikschaltung einen binären Dekrementalzähler. Weiteres ergibt sich im übrigen aus der Beschreibung des Ausführungsbeispiels der Erfindung.

Gemäß den Ansprüchen 6 und 7 ist eine modulare Anordnung von RAM-Bausteinen auf einem von Kontaktflächen freien Träger vorgesehen. Damit ist eine Realisierung der Speichervorrichtung auf einer Bauteil- oder Gehäusefläche eines Gerätes unabhängig von der insbesondere bei implantierbaren Geräten sehr begrenzten Oberfläche des Substrates möglich. Auf dem Substrat, das die weiteren elektronischen Bauteile des Gerätes trägt, muß lediglich eine entsprechende Anzahl von Kontaktflächen für die Anbindung der von der anderweitig untergebrachten Speichereinrichtung herkommenden Leitungen vorgesehen sein.

In vorteilhafter Weise können also RAM-Bausteine mit ansonsten ungenutzten Innenflächen des Gehäuses eines implantierbaren Gerätes oder an einer Substratabdeckung verklebt werden. Damit sind auch nachträgliche Aufstockungen der Speicherkapazität bei einem Gerät vollkommen unabhängig von den gegebenen Raumverhältnissen auf der Substratoberfläche möglich.

Diese bevorzugte Ausführungsform der Erfindung trägt also wesentlich zur Reduzierung der flächenmäßigen Anforderungen durch die Arbeitsspeichervorrichtung an das Substrat bei.

Gemäß einer weiteren bevorzugten Ausführungsform können die RAM-Bausteine in der Speichervorrichtung auch deckungsgleich übereinandergestapelt sein. Für eine solche Anordnung bestimmte RAM-Bausteine weisen dabei eine andere geometrische Ein- und Ausgangskonfiguration auf, wie RAM-Bausteine, die in der Speichervorrichtung planar aneinanderreihbar sind. Im übrigen werden erfindungsgemäße Speichervorrichtungen mit gestapelten RAM-Bausteinen der erfindungsgemäß zugrundeliegenden Aufgabe besonders gerecht. Herkömmliche RAM-Bausteine ermöglichen diese Konfiguration nicht, da bei deckungsgleicher Lage der jeweils höher liegende Baustein die Anschlußflächen des jeweils daunterliegenden verdecken würde.

Weitere Merkmale, Einzelheiten und Vorteile der Erfindung ergeben sich aus der nachfolgenden Beschreibung, in der ein Ausführungsbeispiel des Erfindungsgegenstandes anhand der beigefügten Zeichnungen näher erläutert wird. Es zeigen:
- Fig. 1: ein Blockschaltbild einer elektronischen Speichervorrichtung sowie
- Fig. 2 und 3: eine schematische Draufsicht und Seitenansicht einer modular aufgebauten Speichervorrichtung.

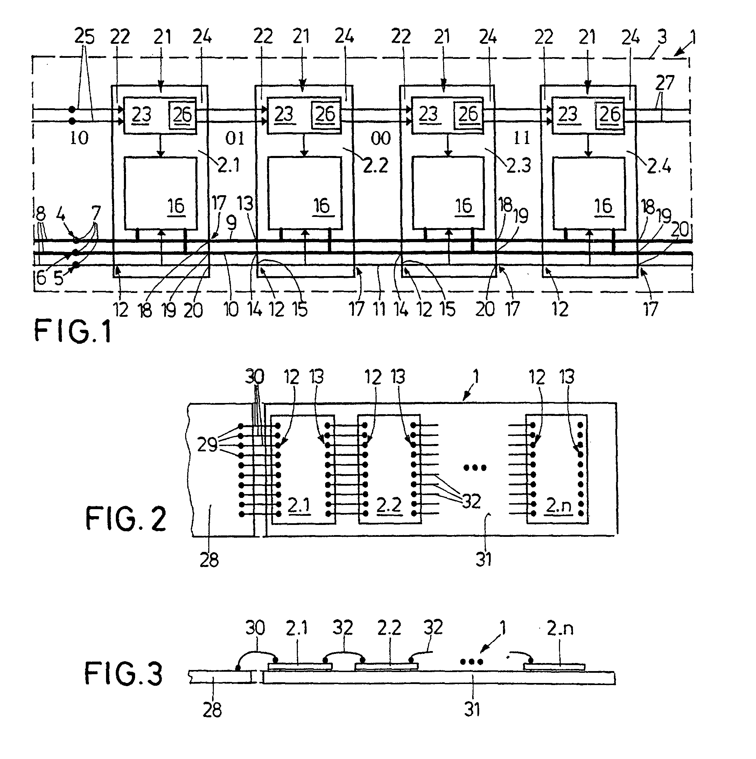

In Fig. 1 ist die gesamte elektronische Speichervorrichtung mit dem Bezugszeichen 1 versehen. Diese weist vier RAM-Bausteine 2.1, 2.2, 2.3 und 2.4 auf, die auf einem strichliert umrissenen Träger 3 lediglich mechanisch befestigt sind. Die Speichervorrichtung 1 weist Adresseingänge 4, einen Schreib/Lese-Eingang 5 und einen Datenbus-Anschluß 6 auf, die beispielsweise durch Kontaktflächen 7 auf dem Träger 3 gebildet sein können. Zu den Kontaktflächen 7 führen übliche Leiterbahnen 8.

An ihren Adresseingang 4 ist der Adressbus 9 der Speichervorrichtung 1 angeschlossen, der beispielsweise fünf Adressleitungen aufweist. Die RAM-Bausteine 2.1 bis 2.4 weisen also eine Speicherkapazität von 2⁵, d. h. 32 Bit auf.

Am Datenbus-Anschluß 6, über den sowohl Daten ein- als auch ausgelesen werden, hängt der Datenbus 10 der Speichervorrichtung, dessen Leitungsanzahl von der Wortbreite der zu speichernden Information abhängt. Ferner ist eine einzelne Schreib/Lese-Leitung 11 vorgesehen.

Jeder der RAM-Bausteine 2.1 bis 2.4 weist eine eingangsseitige Schnittstelle 12 auf, die aus einem Adressbus-Anschluß 13, einem Datenbus-Anschluß 14 und einem Schreib/Lese-Anschluß 15 gebildet ist. Diese Anschlüsse 13 bis 15 sind intern im RAM-Baustein 2.1 bis 2.4 mit der eigentlichen Speichereinheit 16 in üblicher Weise verbunden. Gleichzeitig sind diese eingangsseitigen Anschlüsse 13 bis 15 intern auf den RAM-Bausteinen 2.1 bis 2.4 mit entsprechenden Anschlüssen einer ausgangsseitigen Schnittstelle 17 verbunden. Bei diesen Anschlüssen handelt es sich wiederum um einen Adressbus-Anschluß 18, einen Datenbus-Anschluß 19 und einen Schreib/Lese-Anschluß 20.

Die interne Verbindung zwischen den Adressbus- 18, Datenbus- 19 und Schreib/Lese-Anschlüssen 20 der eingangsseitigen Schnittstelle 12 und ausgangsseitigen Schnittstelle 17 erfolgt dabei in der Regel nicht direkt - also galvanisch -, sondern normalerweise über Signal-Verstärker in den Leitungswegen. Diese Signal-Verstärker arbeiten jeweils nur in einer Richtung, so daß über das Schreib/Lese-Signal die Richtung umgeschaltet wird, in der die Datenbus-Leitungen gerade betrieben werden.

Von den genannten Anschlüssen 18 bis 20 führen direkte Verbindungsleitungen, die in "Die-To-Die-Bond"-Technik ausgeführt sind, zu den entsprechenden Anschlüssen 13 bis 15 des nächsten RAM-Bausteins 2.2 bis 2.4. Aufgrund dieser Architektur stehen alle Signale am Adresseingang 4, Schreib/Lese-Eingang 5 und Datenbus-Anschluß 6 der Speichervorrichtung 1 an den entsprechenden Eingängen aller RAM-Bausteine 2.1 bis 2.4 gleichzeitig an.

Um hier nun eine Aktivierung nur eines RAM-Bausteins zu ermöglichen, ist jeder RAM-Baustein 2.1 bis 2.4 mit einer Adresserweiterungs-Einrichtung 21 versehen, die aus einem Eingangsanschluß 22, einer Adresslogik 23 und einem Ausgangsanschluß 24 besteht. Es sind zwei erweiterte Adress-Leitungen 25 vorgesehen.

Die Adresslogik 23 in jedem RAM-Baustein 2.1 bis 2.4 weist folgende Funktionsweise auf:

Über den Eingangsanschluß 22 wird ein Adresseingangssignal - also ein binärer Eingangswert - eingegeben, z. B. beim RAM-Baustein 2.1 in Fig. 1 die Binärzahl "10". Die RAM-Bausteine 2.1 bis 2.4 werden dann aktiviert, wenn dieser binäre Eingangswert einem Sollwert, z. B. "00" entspricht. Die Adresslogik 23 im RAM-Baustein 2.1 nimmt diesen Vergleich vor und aktiviert den Baustein 2.1 nicht. Ferner ist in der Adresslogik 23 ein Dekrementalzähler 26 integriert, der den Eingangswert nach einer bestimmten Vorschrift konvertiert, im vorliegenden Falle also um "1" dekrementiert. Wird von dem aktuellen Eingangswert "10" am RAM-Baustein 2.1 binär "1" abgezogen, ergibt sich der Binärwert "01", der am Ausgangsanschluß 24 ansteht. Über entsprechende Verbindungsleitungen 27 in "Die-To-Die-Bond"-Technik wird dieser konvertierte Wert an die Adresslogik 23 des zweiten RAM-Bausteins 2.2 weitergegeben. Da auch hier der Eingangswert "10" nicht dem Sollwert "00" entspricht, bleibt auch der RAM-Baustein 2.2 inaktiv. Der Eingangswert "01" wird wiederum um binär "1" dekrementiert, wird also zu "00". Dieser Wert wird über den Ausgangsanschluß 24 des Bausteins 2.2 an den Baustein 2.3 weitergegeben. Dessen Adresslogik erkennt, daß der Eingangswert dem Sollwert "00" entspricht und aktiviert also den Baustein 2.3. Ein Dekrementieren von binär "1" von "00" ergibt "11", welches Binärsignal vom Ausgangsanschluß 24 des Bausteins 2.3 an den letzten Baustein 2.4 weitergegeben wird. Da dieser Wert nicht dem Sollwert "00" entspricht, bleibt auch Baustein 2.4 inaktiv.

Zusammenfassend können durch die obenbezeichneten Adresserweiterungs-Einrichtung 21 vier RAM-Bausteine einzeln adressiert werden.

Geht man nun abweichend von Fig. 1 von einer Speichervorrichtung 1 aus, die lediglich einen einzigen RAM-Speicher 2.1 aufweist, so kann die Speicherkapazität durch Anhängen und direktes elektrisches Verbinden eines zweiten RAM-Bausteins 2.2 verdoppelt werden. Eine Änderung einer Verdrahtung auf einem Substrat ist dabei nicht erforderlich. Es wird stattdessen an die Ausgangsseite eines bereits vorhandenen RAM-Bausteins ein weiterer identischer RAM-Baustein angehängt. Auf diese Weise kann also bei gleichbleibender Gestaltung des Substrats und bei Vorhandensein von beispielsweise zwei erweiterten Adress-Eingängen im Rahmen der beschriebenen Adressenerweiterung die Speicherkapazität um einen Faktor von 2²=4 erhöht werden. Dies kann auch nachträglich bei veränderten Anforderungen an die Speicherkapazität der Speichervorrichtung problemlos durchgeführt werden.

In den Fig. 2 und 3 ist eine modulare Anbringung von RAM-Bausteinen 2 unabhängig von der bei Implantaten sehr begrenzten Oberfläche des Substrats 28 möglich. Auf dem Substrat 28 muß lediglich die entsprechende Anzahl von Kontaktflächen 29 vorhanden sein, die über entsprechende "Die-To-Substrat"-Verbindungen 30 mit dem ersten RAM-Baustein 2.1 verbunden sind. Dieser ist mit den folgenden RAM-Bausteinen 2.2 bis 2.n beispielsweise auf eine schematisch in Fig. 2 und 3 dargestellte Zwischenwand 31 im Gehäuse eines implantierbaren Gerätes aufgeklebt. Zwischen den RAM-Bausteinen 2 sind jeweils "Die-To-Die"-Verbindungsleitungen 32 zwischen den eingangs- und ausgangsseitigen Schnittstellen 12, 17 vorhanden.

## Patentansprüche

1. Elektronische Speichervorrichtung, insbesondere zur Anwendung bei implantierbaren medizinischen Geräten, mit
- einem oder mehreren elektronischen Schreib/Lese-Speicherbausteinen, RAM-Bausteine (2),
- einem Träger (3) zur mechanischen Fixierung des oder der RAM-Bausteine (2),
- Adresseingängen (4),
- einem Schreib/Lese-Eingang (5), und
- einem Datenbus-Anschluß (6)
**dadurch gekennzeichnet, daß**
- der oder die RAM-Bausteine (2) in der Speichervorrichtung jeweils mit zwei Schnittstellen (12, 17) versehen sind, die eingangsseitig und ausgangsseitig bezüglich des jeweiligen RAM-Bausteins (2) angeordnet sind und jeweils Adressbus-, Datenbus- und Schreib/Lese-Anschluß (14, 15, 16, 18, 19, 20) aufweisen, wobei der Adressbus-, Datenbus- und Schreib/Lese-Anschluß (14, 15, 16) der eingangsseitigen Schnittstelle (12) zur Signaldurchleitung durch den RAM-Baustein intern mit dem jeweils zugeordneten Adressbus-, Datenbus- und Schreib/Lese-Anschluß (18, 19, 20) der ausgangsseitigen Schnittstelle (17) verbunden ist.

2. Speichervorrichtung nach Anspruch 1, **dadurch gekennzeichnet, daß** bei Anordnung mehrerer RAM-Bausteine (2.1, 2.2, 2.3, 2.4) in einer Speichervorrichtung (1) vorzugsweise in einem gemeinsamen Gehäuse die eingangsseitige Schnittstelle (12) des ersten RAM-Bausteins (2.1) mit den zugeordneten Adress- und Schreib/Lese-Eingängen (4, 5) sowie dem Datenbus-Anschluß (6) der Speichervorrichtung (1) über eine Baustein-Substrat-Verbindungsleitung (30) gekoppelt sind.

3. Speichervorrichtung nach Anspruch 2, **dadurch gekennzeichnet, daß** die eingangsseitigen Schnittstellen (12) der zweiten und weiteren RAM-Bausteine (2.1, 2.2, 2.3, 2.4) mit den ausgangseitigen Schnittstellen (17) des jeweils vorgeordneten RAM-Bausteins (2.1, 2.2, 2.3, 2.4) kaskadenartig über direkte Baustein-Baustein-Verbindungsleitungen (32) gekoppelt sind.

4. Speichervorrichtung nach einem der Ansprüche 1 bis 4, **dadurch gekennzeichnet, daß** jeder RAM-Baustein (2) mit einer Adresserweiterungs-Einrichtung (21) mit Eingangsanschluß (22), Adresslogik (23) und Ausgangsanschluß (24) versehen ist, bei der jeweils über den Eingangsanschluß (22) ein binärer Eingangswert eingegeben und von der Adresslogik (23) einerseits mit einem Sollwert zur Aktivierung des RAM-Bausteins (2) verglichen und andrerseits der binäre Eingangswert nach einem vorgegebenen Algorithmus in einen binären Ausgangswert konvertiert wird, der an einem Ausgangsanschluß (24) zur Weitergabe als Eingangswert an eine Adresserweiterungs-Einrichtung (21) eines folgenden RAM-Bausteins (2) ansteht.

5. Speichervorrichtung nach Anspruch 4, **dadurch gekennzeichnet, daß** die Adresslogik (23) zur Konversion des Eingangswertes einen binären Dekrementalzähler (26) aufweist.

6. Speichervorrichtung nach einem der Ansprüche 1 bis 5, **dadurch gekennzeichnet, daß** die RAM-Bausteine (2) modular auf einem vorzugsweise Anschlußflächen-freien Träger (31) angeordnet sind.

7. Speichervorrichtung nach Anspruch 6, **gekennzeichnet durch** eine Bauteil- oder Gehäusefläche (31) des die Speichereinrichtung (1) beherbergenden Gerätes als Träger für die RAM-Bausteine (2.1, 2.2, 2.3, 2.4).

8. Speichervorrichtung nach einem der Ansprüche 1 bis 5, **dadurch gekennzeichnet, daß** mehrere RAM-Bausteine (2) in der Speichervorrichtung deckungsgleich übereinandergestapelt sind.

## Claims

1. An electronic memory device, in particular for use in implantable medical appliances with
- one or more electronic read/write memory chips, RAM chips (2),
- a carrier (3) for mechanical fixing of the RAM chip or chips (2),
- address inputs (4),
- a read/write input (5),
- a data bus connection (6)
**characterized in that**
the RAM chip or chips (2) in the memory device are each provided with two interfaces (12, 17) arranged on the input side and output side relative to the respective RAM chip (2) and each comprise address bus, data bus and read/write connection (14, 15, 16, 18, 19, 20), the address bus, data bus and read/write connection (14, 15, 16) of the input-side interface (12) being connected internally to the respectively allocated address bus, data bus and read/write connection (18, 19, 20) of the output-side interface (17) for signal transmission through the RAM chip.

2. A memory device according to claim 1, **characterized in that**, when a plurality of RAM chips (2.1, 2.2, 2.3, 2.4) is arranged in a memory device (1), preferably in a common housing, the input-side interface (12) of the first RAM chip (2.1) is coupled to the associated address and read/write inputs (4, 5) and the data bus connection (6) of the memory device (1) via a chip-substrate connecting line (30).

3. A memory device according to claim 2, **characterized in that** the input-side interfaces (12) of the second and further RAM chips (2.1, 2.2, 2.3, 2.4) are coupled to the output-side interfaces (17) of the respective preceding RAM chip (2.1, 2.2, 2.3, 2.4) in the manner of a cascade via direct chip-chip connecting lines (32).

4. A memory device according to one of claims 1 to 4, **characterized in that** each RAM chip (2) is provided with an address Expansion arrangement (21) with input connection (22), address logic (23) and output connection (24) in which in each case a binary input value is input via the input connection (22) and on the one hand is compared by the address logic (23) with a set value for activation of the RAM chip (2) and, on the other hand, the binary input value is converted according to a predetermined algorithm into a binary output value which is present at an output connection (24) for transmission as input value to an address expansion arrangement (21) of a following RAM chip (2).

5. A memory arrangement according to claim 4, **characterized in that** the address logic (23) comprises a binary decremental counter (26) for converting the input value.

6. A memory arrangement according to one of claims 1 to 5, **characterized in that** the RAM chips (2) are arranged in modular fashion on a carrier (31) which is preferably free from connecting faces.

7. A memory arrangement according to claim 6, **characterized by** a component or housing area (31) of the appliance accommodating the memory arrangement (1) as carrier for the RAM chips (2.1, 2.2, 2.3, 2.4).

8. A memory arrangement according to one of claims 1 to 5, **characterized in that** a plurality of RAM chips (2) is stacked congruently in the memory device.

## Revendications

1. Dispositif de mémoire électronique, en particulier pour utilisation dans des appareils médicaux implantables, comprenant
- un ou plusieurs modules de mémoire électroniques d'écriture/lecture, modules RAM (2),
- un support (3) pour la fixation mécanique du ou des modules RAM (2),
- des entrées d'adresses (4),
- une entrée d'écriture/lecture (5), et
- une connexion de bus de données (6),
**caractérisé en ce que**
- le ou les modules RAM (2) du dispositif de mémoire sont pourvus chacun de deux interfaces (12, 17) qui sont disposées côté entrée et côté sortie par rapport au module RAM (2) respectif et comportent chacun des connexions de bus d'adresses, de bus de données et d'écriture/lecture (14, 15, 16, 18, 19, 20), les connexions de bus d'adresses, de bus de données et d'écriture/lecture (14, 15, 16) de l'interface côté entrée (12) étant connectées en interne, pour le transfert de signal à travers le module RAM, aux connexions respectivement associées de bus d'adresses, de bus de données et d'écriture/lecture (18, 19, 20) de l'interface côté sortie (17).

2. Dispositif de mémoire selon la revendication 1, **caractérisé en ce qu'**en présence de plusieurs modules RAM (2.1, 2.2, 2.3, 2.4) dans un dispositif de mémoire, de préférence dans un boîtier commun, l'interface côté entrée (12) du premier module RAM (2.1) est couplée aux sorties associées d'adresse et d'écriture/lecture (4, 5) ainsi qu'à la connexion de bus de données (6) du dispositif de mémoire (1) par l'intermédiaire d'une ligne de connexion module-substrat (30).

3. Dispositif de mémoire selon la revendication 2, **caractérisé en ce que** les interfaces côté entrée (12) du second module RAM et des suivants (2.1, 2.2, 2.3, 2.4) sont connectées en cascade aux interfaces côté sortie (17) du module RAM immédiatement précédent (2.1, 2.2, 2.3, 2.4) par l'intermédiaire de lignes directes de connexion module-module (32).

4. Dispositif de mémoire selon une des revendications 1 à 4, **caractérisé en ce que** chaque module RAM (2) est pourvu d'un dispositif d'élargissement d'adresse (21) avec connexion d'entrée (22), logique d'adresses (23) et connexion de sortie (24), dans lequel une valeur d'entrée binaire est entrée respectivement par l'intermédiaire de la connexion d'entrée (22) et, d'une part, comparée par la logique d'adresses (23) à une valeur de consigne pour l'activation du module RAM (2) et, d'autre part, convertie selon un algorithme prédéfini en une valeur de sortie binaire, laquelle est disponible à une connexion de sortie (24) pour être transmise comme valeur d'entrée à un dispositif d'élargissement d'adresse (21) d'un module RAM ultérieur (2).

5. Dispositif de mémoire selon la revendication 4, **caractérisé en ce que** la logique d'adresses (23) comporte un compteur décrémentiel binaire (26) pour la conversion de la valeur d'entrée.

6. Dispositif de mémoire selon une des revendications 1 à 5, **caractérisé en ce que** les modules RAM (2) sont disposés de manière modulaire sur un support (31) de préférence sans plot de connexion.

7. Dispositif de mémoire selon la revendication 6, **caractérisé par** une surface de pièce ou de boîtier (31) de l'appareil abritant le dispositif de mémoire (1) faisant fonction de support pour les modules RAM (2.1, 2.2, 2.3, 2.4).

8. Dispositif de mémoire selon une des revendications 1 à 5, **caractérisé en ce que** plusieurs modules RAM (2) sont superposés en coïncidence dans le dispositif de mémoire.
